(19) Europäisches Patentamt / European Patent Office / Office européen des brevets

(11) **EP 4 224 708 A1**

(12) **DEMANDE DE BREVET EUROPEEN**

(43) Date de publication:
**09.08.2023 Bulletin 2023/32**

(21) Numéro de dépôt: **23154892.6**

(22) Date de dépôt: **03.02.2023**

(51) Classification Internationale des Brevets (IPC):
*H03F 1/32* (2006.01)          *H03F 3/187* (2006.01)
*H03F 3/21* (2006.01)          *H03F 3/217* (2006.01)
*H04R 3/04* (2006.01)

(52) Classification Coopérative des Brevets (CPC):
**H03F 3/187; H03F 1/3223; H03F 3/211;**
**H03F 3/217; H04R 3/04;** H03F 2200/03;
H03F 2200/432

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **04.02.2022 FR 2200998**

(71) Demandeur: **Devialet**
**75001 Paris (FR)**

(72) Inventeurs:
• **SEDCOLE, Nicholas, Peter**
**92100 Boulogne Billancourt (FR)**
• **HUFFENUS, Alexandre**
**38000 Grenoble (FR)**
• **MENDES, Eduardo**
**26120 Chabeuil (FR)**

(74) Mandataire: **Lavoix**
**2, place d'Estienne d'Orves**
**75441 Paris Cedex 09 (FR)**

(54) **AMPLIFICATEUR AUDIO**

(57)     Cet amplificateur comporte :
- un générateur (18) de référence ;
- un générateur (19) de puissance, comportant un générateur (20) dont la sortie est connectée à la sortie du générateur de référence (18), au travers d'une inductance (22) ; et
- des moyens (30) de commande du générateur de puissance (19) propres à introduire pour sa commande:

- un signal $L\frac{di_{LOAD}}{dt}$ représentatif du produit de la valeur ($L(i_D)$) de l'inductance (22) et de la dérivée par rapport au temps du courant $\frac{di_{LOAD}}{dt}$ fourni à la charge (16).

Les moyens (30) de commande comportent une boucle de commande ayant une fonction de transfert dépendant de l'impédance complexe ($Z(f)$) de la charge (16).

FIG.1

EP 4 224 708 A1

**Description**

La présente invention concerne un amplificateur audio, du type comportant :

- une entrée pour un signal audio à amplifier et une sortie d'alimentation d'une charge à partir du signal audio amplifié ;
- un générateur de tension de référence, propre à recevoir en entrée le signal audio à amplifier ;
- un générateur de courant de puissance, comportant un générateur de tension de puissance, dont la sortie est connectée à la sortie du générateur de tension de référence, au travers d'une inductance de couplage pour former la sortie d'alimentation de la charge ; et
- des moyens de commande du générateur de courant de puissance propres à introduire en entrée du générateur de courant de puissance pour sa commande :

  - un signal représentatif du courant fourni en sortie par le générateur de tension de référence ; et
  - un signal représentatif du produit de la valeur de l'inductance de couplage et de la dérivée par rapport au temps du courant fourni à la charge.

La demande de brevet WO-2011/107 669 décrit le couplage d'un amplificateur analogique classe A, formé d'un générateur de tension de référence et d'un amplificateur numérique classe D formé d'un générateur de tension de puissance, lequel est couplé à la sortie du générateur de tension de référence par une inductance, avec laquelle il forme alors une source de courant.

L'association d'un amplificateur classe A et d'un amplificateur classe D a pour but de créer un amplificateur de très fort rendement et de très haute linéarité.

En pratique, plusieurs phénomènes limitent le rendement total d'un tel amplificateur, sa capacité à reproduire les hautes fréquences et sa puissance maximale atteignable.

La solution décrite dans le document FR 3 023 088 a pour but d'améliorer le ratio de courant fourni par l'amplificateur classe A sur le courant fourni par l'amplificateur classe D pour des fréquences élevées, permettant ainsi de réduire l'échauffement de l'amplificateur classe A tout en augmentant la bande passante utile.

A cet effet, l'amplificateur audio comporte des moyens pour introduire, pour sa commande, en entrée du générateur de courant, un signal représentatif du produit de la valeur de l'inductance de couplage et de la dérivée par rapport au temps du courant fourni à la charge.

Pour la mise en oeuvre de la solution décrite dans le document précédent, il convient de déterminer, au cours du temps, le courant fourni à la charge. Différents modes de mesure sont décrits dans ce document.

Dans ces différents modes de réalisation, une boucle de contreréaction est créée permettant la mesure du courant de manière directe ou indirecte du courant de sortie. Toutefois, tous ces modes de mesure conduisent à un léger retard dans la commande qui est préjudiciable, notamment lors de la reproduction de signaux sonores de fréquence élevée.

L'invention a pour but de proposer une solution permettant de déterminer efficacement la valeur du produit entre la valeur de l'inductance de couplage et la dérivée par rapport au temps du courant fourni à la charge, et ce quelle que soit la charge.

À cet effet, l'invention a pour objet un amplificateur audio du type précité, caractérisé en ce que lesdits moyens de commande du générateur de courant de puissance comportent une boucle de commande en boucle ouverte reliant l'entrée à l'entrée du générateur de courant pour sa commande et ayant une fonction de transfert dépendant de l'impédance complexe de la charge pour estimer la dérivée par rapport au temps du courant fourni à la charge en fonction de l'impédance complexe de la charge et du signal audio à amplifier à l'entrée.

Suivant des modes particuliers de réalisation, l'amplificateur comporte l'une ou plusieurs des caractéristiques suivantes :

- la boucle de commande en boucle ouverte a une fonction de transfert programmable et l'amplificateur comporte :

  - des moyens de mesure de l'impédance complexe de la charge, et
  - des moyens de programmation initiale de la fonction de transfert de la boucle de commande en fonction de l'impédance complexe mesurée pour estimer la dérivée par rapport au temps du courant fourni à la charge en fonction de l'impédance complexe mesurée et du signal audio à amplifier à l'entrée ;
  - les moyens de mesure de l'impédance complexe de la charge comportent :
  - une source d'injection de signaux sur mesure sur l'entrée de commande du générateur de tension de référence, alors que le générateur de courant de puissance est éteint ;
  - des moyens de mesure de l'intensité du courant fourni à la charge depuis la sortie d'alimentation de la charge ;

- des moyens de calcul de l'impédance complexe de la charge à partir des signaux de mesure et des intensités mesurées des courants fournis à la charge ;
- les moyens de programmation de la fonction de transfert de la boucle de commande en boucle ouverte comportent des moyens de modélisation du chemin entre la source d'injection de signaux de mesure et la sortie pour que la boucle de commande en boucle ouverte impose un délai égal à celui entre le générateur de tension de référence et la sortie d'alimentation de la charge ;
- les moyens de mesure de l'impédance complexe de la charge comportent des moyens de synchronisation de l'injection du signal de test et de la mesure du courant, le délai et le gain entre le générateur et la sortie étant connus ;
- l'impédance complexe est modélisée comme l'impédance d'un filtre R-L-C série ;
- les moyens de programmation de la fonction de transfert de la boucle de commande en boucle ouverte comportent des moyens d'optimisation itérative de la fonction de transfert par variations successives de la valeur de l'impédance complexe mesurée ;
- les moyens de programmation de la fonction de transfert de la boucle de commande en boucle ouverte comportent une mémoire comportant des valeurs précalculées de la fonction de transfert du filtre en fonction d'impédances complexes de la charge ;
- les moyens de programmation de la fonction de transfert de la boucle de commande en boucle ouverte comportent des moyens de perturbation de paramètres initiaux calculés de l'impédance complexe ;
- les moyens de programmation de la fonction de transfert de la boucle de commande en boucle ouverte comportent des moyens de mise en oeuvre d'un algorithme de descente de gradient ;
- la boucle de commande en boucle ouverte est propre à introduire en entrée du générateur de courant pour sa commande, à la fois un signal représentatif du signal audio à amplifier et le produit de la valeur de l'inductance de couplage et de la dérivée par rapport au temps du courant fourni à la charge.

L'invention sera mieux comprise à la lecture de la description qui va suivre, donnée uniquement à titre d'exemple et faite en se référant aux dessins sur lesquels :

- [Fig 1] la figure 1 est un schéma électrique d'un amplificateur audio selon l'invention connecté à un haut-parleur d'impédance connue ;
- [Fig 2] la figure 2 est une version identique à celle de la figure 1 d'un autre mode de réalisation d'un amplificateur audio selon l'invention relié à un haut-parleur d'impédance inconnue ; et
- [Fig 3] la figure 3 est un organigramme de configuration initiale de l'amplificateur de la figure 2.

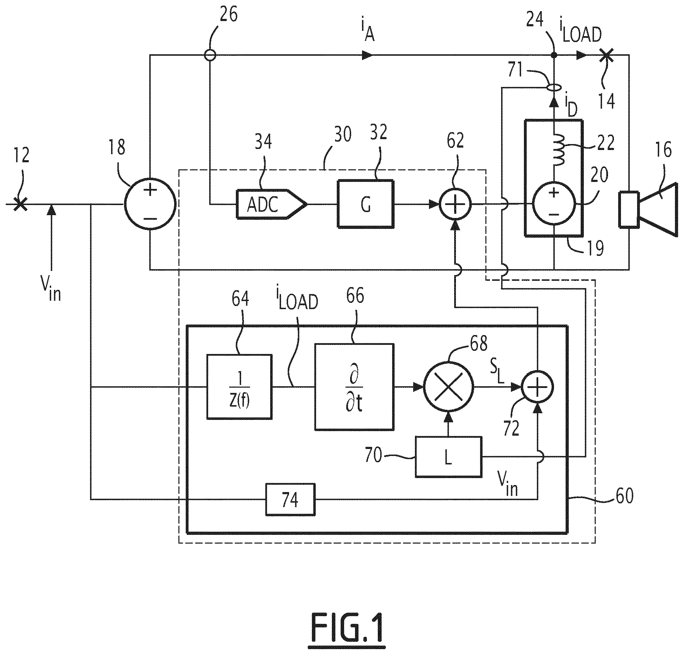

L'amplificateur audio 10 représenté sur la figure 1 comporte une entrée 12 propre à recevoir un signal audio analogique à amplifier $V_{in}$ et une sortie 14 de fourniture du signal amplifié à laquelle est reliée une charge remplaçable formée d'un haut-parleur 16. La sortie 14 comporte des bornes permettant la connexion démontable à différents types de haut-parleurs. Ainsi, le détenteur de l'amplificateur peut en sortie connecter les haut-parleurs de son choix.

Le haut-parleur 16 est relié directement, sans autre élément résistif, entre la sortie 14 de l'amplificateur et la masse.

L'entrée 12 de l'amplificateur est propre à recevoir une tension $V_{in}$ de commande dont la référence est la masse.

L'amplificateur 10 comporte un générateur de tension de référence 18 de très haute linéarité et de faible impédance de sortie formant un amplificateur class A et une source de courant de puissance 19 formant un amplificateur class D, dont les deux sorties sont couplées directement pour former la sortie 14 de l'amplificateur. De préférence, l'impédance de sortie du générateur de tension de référence est inférieure à 0,2 Ohms.

La source de courant de puissance 19 comprend un générateur de tension de puissance 20 et une inductance de couplage 22 reliée en sortie du générateur de tension de puissance 20 et au travers de laquelle le générateur de tension 20 est accouplé au générateur de tension de référence 18 en un point formant la sortie 24. L'inductance de couplage 22 est formée d'une bobine ayant une faible résistance.

L'entrée de commande du générateur de tension de référence 18 est reliée à l'entrée 12 de l'amplificateur, alors que la sortie de l'amplificateur de tension de référence 18 est reliée directement à la sortie 14 sans interposition d'aucun élément résistif, capacitif ou inductif.

Les sorties des générateurs de tension 18 et 20 sont reliées en un point de couplage 24, l'inductance de couplage 22 étant disposée entre la sortie du générateur de tension de puissance 20 et le point de couplage 24.

Le générateur de tension de référence 18 comporte, par exemple, un amplificateur opérationnel monté en suiveur en tension et a donc un gain unitaire.

L'amplificateur 10 comporte un dispositif 26 de mesure du courant $i_A$ fourni par le générateur de tension 18. Le dispositif 26 est de tout type adapté.

Par exemple, lorsque le générateur de tension 18 comporte un amplificateur différentiel alimenté par deux tensions continues V$_+$ et V$_-$ et consomme un courant noté respectivement I$_+$ et I$_-$ sur chacune de ces entrées d'alimentation, des moyens de mesure du courant consommé sont prévus sur chacune des entrées d'alimentation de l'amplificateur différentiel.

Ces moyens sont formés par exemple de détecteurs de courant comme décrits dans le document US 6 937 095. Ils sont propres à fournir une information représentative du courant fourni en sortie par le générateur de tension référence, le courant i$_A$ fourni par le générateur 18 étant directement lié au courant qu'il consomme.

Les sorties des capteurs de courant sont reliées à un sommateur dont la sortie fournit le courant i$_A$ consommé par le générateur de tension de référence et donc le courant fourni en sortie de ce même amplificateur.

La source de courant de puissance 19 comporte une unité de commande 30 du générateur de tension 20 intégré dans la source de courant. Il comporte un régulateur linéaire 32 recevant en entrée le courant i$_A$ en étant connecté au dispositif 26 de mesure du courant i$_A$ au travers d'un convertisseur analogique-numérique 34.

Le régulateur 32 comporte par exemple un étage d'amplification linéaire et un étage d'intégration montés en parallèle et recevant en entrée une valeur représentative du courant i$_A$ produit par le générateur de tension de référence 18. Les sorties des différents étages sont reliées à un sommateur. Ainsi, le régulateur 32 est propre à fournir en sortie un signal représentatif du courant fourni en sortie par le générateur de référence 18.

Le générateur de tension de puissance 20 est formé par exemple d'un amplificateur différentiel monté en suiveur, et dont l'entrée inverseuse est connectée directement à la sortie par une boucle de contre-réaction. Son gain est unitaire.

Son entrée non inverseuse est reliée à la sortie de l'unité de commande 30.

Suivant un premier mode de réalisation, l'amplificateur différentiel est constitué d'un amplificateur de classe D, c'est-à-dire d'un amplificateur de type « push/pull » comportant suivant sa branche d'amplificateur deux transistors « MOSFET » montés en anti-série, ces deux transistors étant pilotés suivant une loi de modulation par largeur d'impulsion. Dans ce cas, l'impédance 22 est constituée d'une inductance, d'une résistance ou de la combinaison des deux. En variante, les deux transistors sont pilotés suivant une loi en sigma/delta.

Suivant un autre mode de réalisation, le générateur de tension de puissance 20 est constitué d'un amplificateur de classe A ou de classe AB.

Avantageusement, l'inductance de couplage 22 a un module inférieur à dix fois le module de la charge, à savoir du haut-parleur 16, dans la gamme de fréquence utile.

Ainsi, par exemple pour un haut-parleur dont la résistance est de 8 Ohms, l'inductance 22 utilisée dans le cas d'un amplificateur de classe AB pour former le générateur de courant de puissance 19 est inférieure à 10$\mu$H.

De même, dans le cas d'un amplificateur de class D formant le générateur de tension de puissance 20, pour alimenter un haut-parleur dont l'inductance est de 1mH et la résistance de 4 Ohms, l'inductance de couplage a une valeur inférieure à 100$\mu$H.

Selon l'invention, l'unité de commande 30 du générateur de courant 19 comporte une boucle de commande 60 en boucle ouverte pour introduire, à l'entrée du générateur de courant 19 pour sa commande, en plus du signal représentatif du courant i$_A$ fourni en sortie du générateur de tension de référence 18, un signal S$_L$ représentatif de la valeur de l'inductance de couplage 22 et de la dérivée par rapport au temps de l'intensité i$_{LOAD}$ circulant dans la charge. La sortie de la boucle 60 est reliée à une entrée d'un sommateur 62 pour la prise en compte du signal S$_L$, l'autre entrée du sommateur 40 étant reliée à la sortie du régulateur 32.

La boucle 60 est reliée en entrée à l'entrée 12. Elle comporte un étage 64 de détermination du courant i$_{LOAD}$ ayant une fonction de transfert appliquant la fonction de transfert 1/Z(f) où Z(f) est l'impédance complexe de la charge 16, laquelle constitue un paramètre mémorisé dans l'étage 64.

En sortie de l'étage 64 est obtenue l'intensité i$_{LOAD}$ fournie à la charge 16 en sortie 14 de l'amplificateur, puisque, le générateur de tension 18 étant de gain unitaire, la tension V$_{in}$ en entrée 12 est la tension aux bornes de la charge 16. La sortie de l'étage 64 est connectée à un étage de dérivation par rapport au temps 66 propre à fournir en sortie $\frac{\partial i_{LOAD}}{\partial t}$ .

Cet étage de dérivation est relié à un multiplicateur 68, dont l'autre borne d'entrée est reliée à un étage 70 de fourniture d'une valeur L(i$_D$) de l'inductance de couplage 22 en fonction du courant i$_D$ la traversant. Cet étage 70 comporte par exemple une entrée propre à recevoir l'intensité i$_D$ traversant l'inductance 22, cette entrée étant reliée à un capteur de courant 71 installé en sortie du générateur de courant 19.

L'unité 70 est formée par exemple d'une table de valeurs préenregistrées propres à fournir en sortie la valeur L(i$_D$) de l'inductance 22 en fonction de l'intensité i$_D$ circulant dans cette inductance.

En variante, le capteur de courant 71 est supprimé et l'unité 70 contient une unique valeur de L qui est appliquée quel que soit le courant i$_D$.

La sortie du multiplicateur 68 est reliée à un sommateur 72 dont la sortie est reliée au sommateur 62. La sortie du multiplicateur 68 fournit le signal $S_L$, lequel est égal au produit de l'inductance du couplage $L(i_D)$ et de la dérivée par rapport au temps du courant fourni à la charge depuis la sortie 14 soit $S_L = L(i_D)\frac{\partial i_{LOAD}}{\partial t}$ .

Le sommateur 72 est connecté par une autre entrée à l'entrée 12, par l'intermédiaire d'un étage d'amplification linéaire 74 pour recevoir le signal musical $V_{in}$ à amplifier.

On comprend qu'avec un tel circuit, la tension ajoutée pour la commande du générateur de courant de puissance 19, en plus de la sortie du régulateur 32 est égale à $V = V_{in} + L\frac{di_{LOAD}}{dt}$ .

Dans le cas où la sortie du régulateur 32 est égale à zéro (le générateur de tension de référence 18 ne fournit alors aucun courant), comme les générateurs de référence 18 et de puissance 20 sont à gain unitaire, la tension au point 24 vaut Vin et la tension de sortie du générateur de tension de puissance 20 vaut $V = V_{in} + L\frac{di_{LOAD}}{dt}$ .

La tension aux bornes de l'inductance 22 est alors égale à la différence des deux tensions précédentes, soit

$$V_L = V_{in} - \left(V_{in} + L\frac{di_{LOAD}}{dt}\right) = -L\frac{di_{LOAD}}{dt}$$ .

Il en découle immédiatement que l'inductance 22 est parcourue par le courant $i_{LOAD}$, car une inductance L traversée par un courant i voit naitre à ses bornes une différence de potentiel égale à $-L\frac{di}{dt}$ .

Dans ces conditions, l'intégralité du courant fourni à la charge 16 provient du générateur de tension de puissance 20. Le signal $V = V_{in} + L\frac{di_{LOAD}}{dt}$ est donc un estimateur parfait de la tension à fournir au générateur 20 pour maximiser le ratio $\frac{i_D}{i_A}$ .

La boucle de commande 60 a été décrite ici comme un ensemble de modules discrets pour permettre la compréhension de l'invention.

En pratique, la boucle de commande 60 est un composant programmable propre à appliquer une équation aux différences :

$$y[k] = b_0(u[k] - 2u[k-1] + u[k-2] - b_1 y[k-1] - b_2 y[k-2])$$

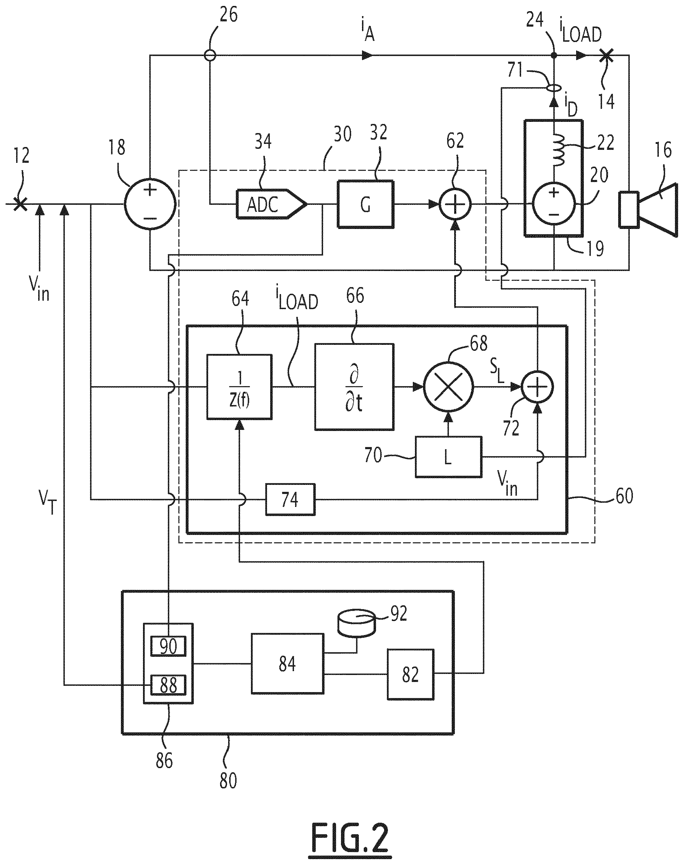

équivalente à la combinaison des modules discrets illustrés sur la figure 2 et fournissant en sortie $V = V_{in} + L(i_D)\frac{\partial i_{LOAD}}{\partial t}$ .

Dans ce premier mode de réalisation, le courant fourni à la charge est estimé à partir de la connaissance de la tension appliquée à l'entrée, c'est-à-dire la tension du signal audio à reproduire et des caractéristiques de la charge. Toutefois, dans le cas d'un amplificateur fourni sans haut-parleurs, les caractéristiques de la charge sont inconnues.

Le second mode de réalisation décrit en regard des figures 1 et 2 résout ce problème et permet l'implémentation de l'invention, même sans connaissance des caractéristiques de la charge.

Ainsi, dans le mode de réalisation de la figure 2, l'étage 64 de détermination du courant $i_{LOAD}$ est programmable et est propre à appliquer toute fonction de transfert reçue pour sa programmation.

L'amplificateur 10 comporte en outre des moyens 80 de programmation initiale de l'équation aux différences de la boucle de commande 60.

À cet effet, les moyens 80 comportent des moyens 82 de chargement des coefficients $b_0$, $b_1$, $b_2$ dans la boucle de commande 60. Ces moyens 82 de chargement sont alimentés par une unité de calcul 84 elle-même reliée à une unité de mesure 86 de l'impédance complexe Z(f) du haut-parleur 16.

Ces moyens de mesure 86 comportent une source 88 d'injection de signaux de test à l'entrée 12 de l'amplificateur et des moyens non représentés d'extinction du générateur de courant 19 pendant l'injection des signaux de test.

Ils comportent en outre des moyens de recueil 90 de l'intensité du courant $i_A$ produit par le générateur de tension 18 lors de l'application des signaux de test. Les moyens de recueil 90 sont reliés en sortie du convertisseur analogique-numérique 34 qui reçoit une information représentative du courant $i_A$ depuis le dispositif de mesure 26.

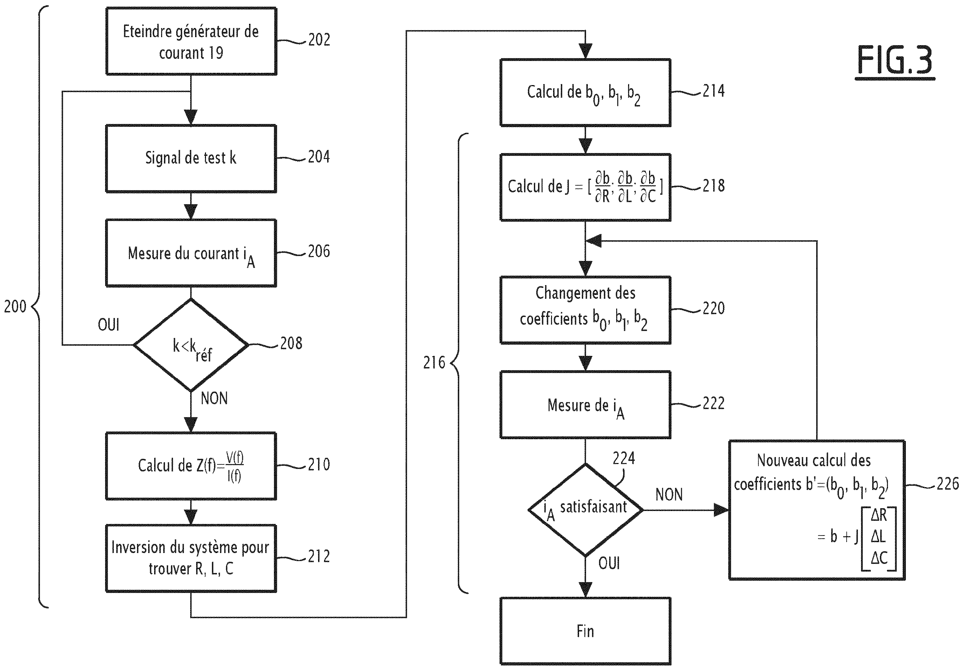

L'unité de calcul 84 est propre à mettre en oeuvre l'algorithme de configuration illustré sur la figure 3 et stocké dans une mémoire 92 lors de la mise en route de l'amplificateur par exemple ou à des moments prédéterminés en dehors des plages de reproduction d'un signal sonore depuis l'entrée 12.

La configuration commence par une phase de calibration 200.

Ainsi, sous la commande des moyens de mesure 86, le générateur de courant 19 est d'abord éteint à l'étape 202. Après quoi, un signal de test $V_T$ d'amplitude constante et de fréquence constante connues est émis depuis la source 88 à l'étape 204.

Le courant produit par le générateur de tension 18 est mesuré à l'étape 206. Les étapes 204 à 208 sont reproduites pour un nombre prédéterminé k de signaux de test ayant des fréquences différentes et chacun une amplitude fixe.

À partir des couples $(V_T, i_A)$ de mesures effectuées à partir des signaux de test, l'impédance complexe Z(f) de la charge 16 est déterminée à l'étape 210 par résolution d'un système linéaire, chaque signal de test donnant lieu à une équation de ce système exprimant la tension de test $V_T$ injectée en fonction du courant $i_A$ mesuré et reçu par les moyens de recueil 90.

L'impédance complexe Z(f) est définie par une norme et par une phase.

Suivant un premier mode de réalisation, la phase entre le signal de test $V_T$ et l'intensité $i_A$ mesurée est obtenue à partir de la mesure de la tension réalisée en même temps que celle du courant. En pratique, l'amplificateur reçoit en entrée un signal numérique et un convertisseur numérique-analogique est prévu pour commander l'entrée 12. La tension est donc connue numériquement en entrée.

Suivant un deuxième mode de réalisation, la phase entre la tension du signal de test $V_T$ et l'intensité $i_A$ est mesurée directement avec deux détecteurs de passage à zéro et un chronomètre.

Suivant un troisième mode de réalisation, les moyens 86 comportent des moyens de synchronisation de la génération du signal de test $V_T$ et de la capture du courant $i_A$. Le délai et le gain entre le générateur et la sortie V sont connus et pris en compte par la suite.

Pour ce faire, la capture du courant $i_A$ est déclenchée à un temps fixe après le lancement du générateur du signal de test $V_T$.

Suivant encore un quatrième mode de réalisation, les moyens 80 comportent des moyens de programmation de la boucle 60 pour qu'elle modélise le chemin entre le générateur du signal de test 88 et la sortie 14 pour que la boucle de commande en boucle ouverte 60 impose un délai égal à celui entre le générateur de tension de référence 18 et la sortie 14 d'alimentation de la charge 16.

Avantageusement, en vue de sa détermination à l'étape 210, l'impédance de la charge 16 est modélisée comme un circuit R-L-C série.

Ainsi, chaque impédance mesurée est composée d'une résistance R(f) et d'une réactance X(f) :

$$Z(f) = R(f) + jX(f)$$

La réactance X(f) est modélisée par une inductance L et une capacitance C en série, elle s'écrit sous la forme :

$$X(f) \approx 2\pi f L - \frac{1}{2\pi f C}$$

Les mesures faites par les moyens 86 alimentent un système d'équations linéaires, dont la résolution à l'étape 212 par l'unité de calcul 84 donne les paramètres R, L et C du modèle avec pour L et C le système suivant :

$$\begin{bmatrix} 2\pi f_1 & \dfrac{-1}{2\pi f_1} \\ 2\pi f_2 & \dfrac{-1}{2\pi f_2} \end{bmatrix} \begin{bmatrix} L \\ \dfrac{1}{C} \end{bmatrix} = \begin{bmatrix} X(f_1) \\ X(f_2) \end{bmatrix}$$

Le système est surcontraint pour R avec 2 fréquences ou plus, et surcontraint pour L et C avec 3 fréquences ou plus.

Le système est inversé à l'étape 212 pour trouver les valeurs des paramètres R, L, C.

La boucle de commande 60 est modélisée à l'étape 214 comme un filtre dont l'équation aux différences est

$$y[k] = b_0 \left( u[k] - 2u[k-1] + u[k-2] - b_1 y[k-1] - b_2 y[k-2] \right),$$

avec

$$b_0 = \frac{4L_1}{L + \frac{R}{f_s} + \frac{1}{Cf_s^2}},$$

$$b_1 = -\frac{2L + \frac{R}{f_s}}{4L_1},$$

$$b_2 = \frac{L}{4L_1},$$

où L1 est la valeur de l'inductance 22, $f_s$ est la fréquence d'échantillonnage du modèle discret et L, R et C sont les valeurs calculées des paramètres du modèle RLC.

À l'issue du calcul des coefficients $b_0$, $b_1$, $b_2$, une optimisation 216 des coefficients $b_0$, $b_1$, $b_2$ initialement obtenus est effectuée de manière itérative en faisant varier les valeurs des paramètres R, L, C précédemment déterminés. Le générateur de courant 19 est alors remis en route.

L'objectif de cette optimisation est de minimiser le courant $i_A$ fourni par le générateur de tension de référence 18 avec le générateur de courant 19 allumé.

Pour limiter la quantité de calcul à chaque itération, la projection de l'espace de paramètres R, L, C vers l'espace des coefficients $b_0$, $b_1$, $b_2$ du modèle est calculée à partir d'une première estimation des coefficients, pour une zone restreinte autour de cette estimation, où il est présumé que la projection est linéaire.

Suivant une première approche, les paramètres initiaux sont perturbés et plusieurs points dans l'espace des coefficients sont calculés. Par exemple, la valeur du paramètre R est variée par +10% par rapport la valeur initiale tout en gardant constantes les valeurs de L et de C, et les coefficients du modèle sont calculés. Cette opération est répétée pour L et pour C. Les différences entre les coefficients initiaux et les coefficients perturbés sont présumées être proportionnelles au changement de la valeur du paramètre correspondant, et ainsi font une estimation du gradient en trois dimensions. Une estimation de la projection d'un point arbitraire depuis l'espace R, L, C dans l'espace des coefficients est alors calculée facilement.

Suivant une seconde approche, le gradient de l'espace des coefficients par rapport aux paramètres R, L, C est calculé analytiquement à l'étape 218. Cela se résume à calculer la matrice des dérivées partielles, dit la jacobienne :

$$\mathbf{J} = \left[ \frac{\partial \mathbf{b}}{\partial R} \quad \frac{\partial \mathbf{b}}{\partial L} \quad \frac{\partial \mathbf{b}}{\partial C} \right]$$

Par exemple, pour une charge supposée formée d'un RLC en série, les coefficients du modèle étant :

$$b_0 = \frac{4L_1}{L + \frac{R}{f_s} + \frac{1}{Cf_s^2}} \qquad b_1 = -\frac{2L + \frac{R}{f_s}}{4L_1} \qquad b_2 = \frac{L}{4L_1}$$

La jacobienne J est :

$$\mathbf{J} = \begin{bmatrix} \dfrac{-4L_1}{f_s\left(L + R/f_s + 1/Cf_s^2\right)^2} & \dfrac{-4L_1}{\left(L + R/f_s + 1/Cf_s^2\right)^2} & \dfrac{4L_1}{C^2 f_s^2 \left(L + R/f_s + 1/Cf_s^2\right)^2} \\[3mm] \dfrac{-1}{4L_1 f_s} & \dfrac{-1}{2L_1} & 0 \\[3mm] 0 & \dfrac{1}{4L_1} & 0 \end{bmatrix}$$

qui peut être exprimée dans la forme :

$$\mathbf{J} = \dfrac{1}{4L_1} \begin{bmatrix} \dfrac{-1}{f_s} & -1 & \dfrac{1}{f_s^2} \\[3mm] \dfrac{-1}{f_s} & -2 & 0 \\[3mm] 0 & 1 & 0 \end{bmatrix} \circ \begin{bmatrix} b_0^2 & b_0^2 & \dfrac{b_0^2}{C^2} \\[2mm] 1 & 1 & 1 \\[2mm] 1 & 1 & 1 \end{bmatrix}$$

Les coefficients $b_0$, $b_1$, $b_2$ déterminés sont chargés à l'étape 220 à partir des moyens de transfert 84 alors que le générateur de courant 19 est en route. Aucun signal d'entrée extérieur $V_{in}$ n'est fourni à l'amplificateur qui est alors hors ligne, mais les deux générateurs de tension 18 et 20 sont mis en marche, de même que tous les modules de l'amplificateur. Un signal de test, typiquement une sinusoïde, est appliqué à l'entrée 14 par les moyens de mesure 86.

Une mesure de $i_A$ est effectuée à l'étape 222.

Un test est effectué sur la fin de l'optimisation à l'étape 224 et tant que le critère d'arrêt retenu pour l'optimisation n'est pas atteint, les étapes 226 et suivantes sont mises en oeuvre.

À l'étape 226, des variations $\Delta R$, $\Delta L$, $\Delta C$ sont déterminées comme connu en soi par mise en oeuvre d'un algorithme d'optimisation connu de l'Homme du Métier, dont l'algorithme de descente de gradient est un exemple. Ces variations sont appliquées pour calculer de nouveaux coefficients b' = ($b'_0$, $b'_1$, $b'_2$) pour le modèle en fonction des coefficients b = ($b_0$, $b_1$, $b_2$) du précédent modèle par la formule :

$$\mathbf{b'} = \mathbf{b} + \mathbf{J} \begin{bmatrix} \Delta R \\ \Delta L \\ \Delta C \end{bmatrix}.$$

Par exemple, les variations de $\Delta R$, $\Delta L$, $\Delta C$ sont de $\pm$ 10 % autour des valeurs de R, L, C calculées.

Les nouveaux coefficients $b_0$, $b_1$, $b_2$ sont à nouveau chargés à l'étape 220 et l'algorithme d'optimisation se poursuit.

Après l'achèvement de l'optimisation 216, l'amplificateur configuré est alors pleinement opérationnel.

En cas de changement de haut-parleur formant la charge 16, la configuration est refaite. Avantageusement, cette configuration est mise en oeuvre automatiquement pour toute nouvelle mise sous tension de l'amplificateur.

On comprend qu'avec un tel amplificateur, quelle que soit la charge 16, le courant fourni par le générateur de tension 18 formant idéalement un amplificateur classe A est minimal.

Suivant un autre mode de réalisation, la valeur représentative du courant fourni par le générateur de tension de référence introduite dans le régulateur PI 32 est donnée par la différence des potentiels mesurés aux bornes de l'inductance 22 et d'une résistance complémentaire disposée entre le point de couplage 24 et la sortie 14 suivant le montage décrit dans le document FR 2 873 872.

**Revendications**

1.  Amplificateur audio comportant :

    - une entrée (12) pour un signal audio à amplifier ($V_{in}$) et une sortie (14) d'alimentation d'une charge (16) à partir du signal audio amplifié ;
    - un générateur (18) de tension de référence, propre à recevoir en entrée le signal audio à amplifier ($V_{in}$) ;

- un générateur de courant (19) de puissance, comportant un générateur (20) de tension de puissance, dont la sortie est connectée à la sortie du générateur de tension de référence (18), au travers d'une inductance de couplage (22) pour former la sortie (14) d'alimentation de la charge ; et
- des moyens (30) de commande du générateur de courant de puissance (19) propres à introduire en entrée du générateur de courant de puissance (19) pour sa commande :
- un signal représentatif du courant ($i_A$) fourni en sortie par le générateur de tension de référence (18) ; et
- un signal ($L \dfrac{di_{LOAD}}{dt}$) représentatif du produit de la valeur ($L(i_D)$) de l'inductance de couplage (22) et de la dérivée par rapport au temps du courant (($\dfrac{di_{LOAD}}{dt}$) fourni à la charge (16),

**caractérisé en ce que** lesdits moyens (30) de commande du générateur de courant de puissance (19) comportent une boucle de commande en boucle ouverte (60) reliant l'entrée (12) à l'entrée du générateur de courant (19) pour sa commande et ayant une fonction de transfert dépendant de l'impédance complexe (Z(f)) de la charge (16) pour estimer la dérivée par rapport au temps du courant fourni à la charge (16) ($\dfrac{di_{LOAD}}{dt}$) en fonction de l'impédance complexe (Z(f)) de la charge et du signal audio à amplifier ($V_{in}$) à l'entrée (12).

2. Amplificateur selon la revendication 1, **caractérisé en ce que** la boucle de commande en boucle ouverte (60) a une fonction de transfert programmable
et **en ce que** l'amplificateur comporte :

- des moyens (86) de mesure de l'impédance complexe (Z(f)) de la charge (16), et
- des moyens (80) de programmation initiale de la fonction de transfert de la boucle de commande (60) en fonction de l'impédance complexe (Z(f)) mesurée pour estimer la dérivée par rapport au temps du courant fourni à la charge (16) ($\dfrac{di_{LOAD}}{dt}$) en fonction de l'impédance complexe (Z(f)) mesurée et du signal audio à amplifier ($V_{in}$) à l'entrée (12).

3. Amplificateur selon la revendication 2, **caractérisé en ce que** les moyens de mesure (86) de l'impédance complexe de la charge comportent :

- une source (88) d'injection de signaux sur mesure ($V_T$) sur l'entrée de commande du générateur de tension de référence (18), alors que le générateur de courant de puissance (19) est éteint ;
- des moyens (34, 90) de mesure de l'intensité ($i_A$) du courant fourni à la charge (16) depuis la sortie (14) d'alimentation de la charge ;
- des moyens (84) de calcul de l'impédance complexe de la charge (16) à partir des signaux de mesure ($V_T$) et des intensités mesurées ($i_A$) des courants fournis à la charge (16).

4. Amplificateur selon la revendication 3, **caractérisé en ce que** les moyens (80) de programmation de la fonction de transfert de la boucle de commande en boucle ouverte (60) comportent des moyens de modélisation du chemin entre la source (88) d'injection de signaux de mesure et la sortie (14) pour que la boucle de commande en boucle ouverte (60) impose un délai égal à celui entre le générateur de tension de référence (18) et la sortie (14) d'alimentation de la charge (16).

5. Amplificateur selon la revendication 3, **caractérisé en ce que** les moyens (86) de mesure de l'impédance complexe (Z(f)) de la charge (16) comportent des moyens de synchronisation de l'injection du signal de test ($V_T$) et de la mesure du courant ($i_A$), le délai et le gain entre le générateur et la sortie (V) étant connus.

6. Amplificateur selon l'une quelconque des revendications précédentes, **caractérisé en ce que** l'impédance complexe est modélisée comme l'impédance d'un filtre R-L-C série.

7. Amplificateur selon l'une quelconque des revendications 2 à 6, **caractérisé en ce que** les moyens (80) de programmation de la fonction de transfert de la boucle de commande en boucle ouverte (60) comportent des moyens d'optimisation (216) itérative de la fonction de transfert par variations successives de la valeur de l'impédance complexe mesurée.

8. Amplificateur selon l'une quelconque des revendications 2 à 7, **caractérisé en ce que** les moyens (80) de programmation de la fonction de transfert de la boucle de commande en boucle ouverte (F) comportent une mémoire comportant des valeurs précalculées de la fonction de transfert du filtre en fonction d'impédances complexes de la charge (16).

9. Amplificateur selon l'une quelconque des revendications 2 à 8, **caractérisé en ce que** les moyens (80) de programmation de la fonction de transfert de la boucle de commande en boucle ouverte (F) comportent des moyens de perturbation de paramètres initiaux calculés de l'impédance complexe (Z(f)).

10. Amplificateur selon l'une quelconque des revendications 2 à 8, **caractérisé en ce que** les moyens (80) de programmation de la fonction de transfert de la boucle de commande en boucle ouverte (F) comportent des moyens de mise en oeuvre d'un algorithme de descente de gradient.

11. Amplificateur selon l'une quelconque des revendications précédentes, **caractérisé en ce que** la boucle de commande en boucle ouverte (60) est propre à introduire en entrée du générateur de courant (19) pour sa commande, à la fois un signal représentatif du signal audio à amplifier ($V_{in}$) et le produit de la valeur ($L(i_D)$) de l'inductance de couplage (22) et de la dérivée par rapport au temps du courant ($\frac{di_{LOAD}}{dt}$) fourni à la charge (16).

FIG.1

FIG.2

FIG.3

Europäisches
Patentamt

European
Patent Office

Office européen
des brevets

# RAPPORT DE RECHERCHE EUROPEENNE

Numéro de la demande

**EP 23 15 4892**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A,D | FR 3 023 088 B1 (DEVIALET [FR]) 22 juillet 2016 (2016-07-22) * page 1 - page 11; figures 1-5 * ----- | 1-11 | INV. H03F1/32 H03F3/187 H03F3/21 |
| A,D | WO 2011/107669 A1 (DEVIALET [FR]; CALMEL PIERRE-EMMANUEL [FR]; MORONVALLE MATHIAS [FR]) 9 septembre 2011 (2011-09-09) * page 1 - page 5; figure 1 * ----- | 1-11 | H03F3/217 H04R3/04 |
| A | US 2011/304397 A1 (STANLEY GERALD R [US]) 15 décembre 2011 (2011-12-15) * alinéa [0002] - alinéa [0087]; figures 1-10 * ----- | 1-11 | |
| A | US 5 905 407 A (MIDYA PALLAB [US]) 18 mai 1999 (1999-05-18) * colonne 1 - colonne 9; figures 1-15 * ----- | 1-11 | |

**DOMAINES TECHNIQUES RECHERCHES (IPC)**

H03F
H04R

Le présent rapport a été établi pour toutes les revendications

| Lieu de la recherche | Date d'achèvement de la recherche | Examinateur |
|---|---|---|
| La Haye | 30 mars 2023 | Rafflenbeul, A |

EPO FORM 1503 03.82 (P04C02)

# EP 4 224 708 A1

## ANNEXE AU RAPPORT DE RECHERCHE EUROPEENNE
## RELATIF A LA DEMANDE DE BREVET EUROPEEN NO.

EP 23 15 4892

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

30-03-2023

| Document brevet cité au rapport de recherche | | Date de publication | Membre(s) de la famille de brevet(s) | | Date de publication |
|---|---|---|---|---|---|
| FR 3023088 | B1 | 22-07-2016 | BR | 112016030591 A2 | 22-08-2017 |
| | | | CA | 2953801 A1 | 30-12-2015 |
| | | | CN | 106575952 A | 19-04-2017 |
| | | | EP | 3161959 A1 | 03-05-2017 |
| | | | FR | 3023088 A1 | 01-01-2016 |
| | | | JP | 6925695 B2 | 25-08-2021 |
| | | | JP | 2017525264 A | 31-08-2017 |
| | | | KR | 20170023166 A | 02-03-2017 |
| | | | US | 2017214365 A1 | 27-07-2017 |
| | | | WO | 2015197764 A1 | 30-12-2015 |
| WO 2011107669 | A1 | 09-09-2011 | BR | 112012022177 A2 | 25-10-2016 |
| | | | CN | 103004083 A | 27-03-2013 |
| | | | EP | 2543142 A1 | 09-01-2013 |
| | | | JP | 5503027 B2 | 28-05-2014 |
| | | | JP | 2013521688 A | 10-06-2013 |
| | | | KR | 20130009800 A | 23-01-2013 |
| | | | US | 2014050335 A1 | 20-02-2014 |
| | | | WO | 2011107669 A1 | 09-09-2011 |
| US 2011304397 | A1 | 15-12-2011 | CN | 102386867 A | 21-03-2012 |
| | | | EP | 2395656 A1 | 14-12-2011 |
| | | | JP | 5377578 B2 | 25-12-2013 |
| | | | JP | 2012005121 A | 05-01-2012 |
| | | | US | 2011304397 A1 | 15-12-2011 |
| US 5905407 | A | 18-05-1999 | AUCUN | | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2011107669 A
- FR 3023088 A
- US 6937095 B
- FR 2873872